Europäisches Patentamt

(19) **European Patent Office**

**Office européen des brevets**

(11) Publication number: **0 115 412**
**A2**

(12) # EUROPEAN PATENT APPLICATION

(21) Application number: **84300381.5**

(22) Date of filing: **23.01.84**

(51) Int. Cl.³: **H 01 L 21/48**
**H 01 L 23/14**

(30) Priority: **27.01.83 GB 8302216**

(43) Date of publication of application:
**08.08.84 Bulletin 84/32**

(84) Designated Contracting States:
**DE FR IT NL SE**

(71) Applicant: **UNITED KINGDOM ATOMIC ENERGY**
**AUTHORITY**
**11 Charles II Street**
**London SW1Y 4QP(GB)**

(72) Inventor: **Cairns, James Anthony**
**22 Haywards Close Garston Lane**
**Wantage Oxon(GB)**

(72) Inventor: **Cole, Kevin Stephen**
**11 Longworth Avenue Tilehurst**
**Reading Berkshire(GB)**

(72) Inventor: **Scott, Keith Taylor**
**6 Longworth Road Thatcham**
**Newbury Berkshire(GB)**

(72) Inventor: **Woodhead, James Louis**
**79 Queensway**
**Didcot Oxon(GB)**

(72) Inventor: **Prentice, Thomas Campbell**
**2 The House**
**Chilton Oxon(GB)**

(74) Representative: **Mansell, Keith Rodney**
**Patents Branch United Kingdom Atomic Energy**
**Authority 11 Charles II Street**
**London SW1Y 4QP(GB)**

(54) Coating for electronic substrate.

(57) A coated substrate for use in the manufacture of an
electronic device is made by providing a substrate with an
adherent coating.

The coating is provided by thermally spraying material
onto the substrate, for example by plasma spraying particles
of a mixture of oxides of size 2 to 30 μm onto a metallic
substrate, to give a coating having controlled properties for
electronic purposes, for example, in respect of high dielectric
strength, surface roughness and chemistry. An electronic
circuit may be applied to the coated substrate by methods
known in the art such as screen printing. Very satisfactory
voltage break down characteristics are obtained; also, the
substrate need not necessarily be subjected to a possibly
deleterious heat treatment.

EP 0 115 412 A2

- 1 -

Coated Substrate

This invention relates to a method of making a coated substrate for use in the manufacture of an electronic device.

It is known to make a coated substrate for electronic applications by coating a ceramic substrate with a very smooth glaze. An electronic circuit may then be deposited directly upon the glaze which is required to possess a high degree of surface smoothness to prevent formation of pin holes and other imperfections in the deposited electronic circuit and to allow fine lines to be printed thereon and ohmic losses due to variable line height to be minimised.

Ceramic substrates have the advantage of comparative chemical inertness but have the disadvantages of being brittle, having co-efficients of thermal expansion differing considerably from those of materials deposited upon them, having poor thermal conductivity compared with many metals, and being limited to a low area form. Metallic substrates have accordingly been investigated and "Electronics Weekly" of 14th October 1982 describes, on page 14, a substrate for thick film circuit applications consisting of glass-ceramic coated metal. The metal is stated to be an Fe-Cr-Al alloy with additions of Y and the coating of glass-ceramic is stated to comprise a lithium-zinc- silicate glass-ceramic having good electrical properties including high surface and volume resistivity. Reference is also made, in respect of metallic substrates, to RCA Review, Vol 42 No 2 (June 1981).

Hitherto, a problem in the preparation of coated substrates for electronic purposes has been the need to carry out a thermal treatment step. This has the disadvantage that it may cause damage to the substrate. The present invention may be capable of ameliorating this problem and may also provide a way of producing coatings of controlled properties, for example, in respect of high dielectric strength and compatibility with deposited electronic circuits, on a wide variety of substrates.

Thus, the invention provides a method of making a coated substrate for use in the manufacture of an electronic device comprising thermally spraying a material onto a substrate to produce an adherent coating thereon, the material and the conditions of spraying being such that the coating has controlled properties for electronic purposes.

The controlled properties may include, for example, dielectric strength, surface roughness and chemistry. A coating may be produced by thermal spraying having highly satisfactory dielectric strength for certain electronic purposes, i.e. the coating may be a dielectric coating. If desired the substrate on which the coating is provided need only be subjected to very mild thermal treatment in production of that coating thereon.

The coating may, if and where desired, coat the substrate evenly up to its edges, i.e. areas at the edge of the substrate need not be left uncoated nor need there be a 'meniscus' effect at such an edge or at any holes in the substrate. Where required, the coatings may satisfactorily be provided on a substrate of relatively complex shape and also on the walls defining a hole or holes in a substrate. Also, the coating may be provided on the substrate in the form of a pattern if required. The above features may be particularly important for certain applications.

'Thermal spraying' is a generic term for a method of spraying a solid material by causing it to become molten and projecting the molten material with high kinetic energy onto a target which is, in this case, the substrate. 'Thermal spraying' includes plasma spraying and flame spraying though the former is preferred in the practice of the invention. These techniques are known and reference is made to "The preparation and properties of powders for flame and plasma spraying" by R. L. Nelson, J. L. Woodhead, K. T. Scott, L L. Wassell and A. G. Cross at the VIIth International Metal Spraying Conference (P51), London, September 1973 for discussion of material for thermal spraying. In plasma spraying, the material in powdered form is rapidly heated in a DC arc-plasma and then projected at high velocity in the molten or plastic state onto the substrate surface where it quenches and adheres to produce the coating. For example, the heat source in the plasma process may be an electric arc struck between two electrodes, the anode of which serves as a nozzle. By suitable design, the arc is constricted and stabilized within the latter, generating temperatures up to 20,000°K with the ionised gases being ejected at exit velocities of several hundred metres per second. This arc plasma is a source of high thermal and kinetic energy to entrained material. Most guns use nitrogen, argon or helium as the main plasma gas and operate at power levels between 220 and 80 KW.

Thermal spraying has the advantage of lessening risk of damage or distortion to the substrate because the latter is not subjected to high temperatures during spraying. This also alleviates the likelihood of dimensional changes in the coating, due, e.g. to shrinkage. However, subsequent firing is not precluded and, in some cases, a subsequent firing step may be necessary in order to deposit certain materials onto the coated substrate to constitute an electronic circuit thereon. In other cases, however, it may be possible to deposit material onto the coated substrate to constitute the circuit without the necessity for firing to be carried out.

The material to be thermally sprayed in the invention may be a refractory oxide or a mixture of one or more refractory oxides. Examples of such oxides are $Al_2O_3$, $SiO_2$, ZnO, $B_2O_3$, $ZrO_2$, CaO, MgO, BaO wherein a mixture of $Al_2O_3$ and $SiO_2$ (e.g. with 96% $Al_2O_3$ and 4% $SiO_2$ by weight) is particularly preferred. The material may conveniently be made by spray drying a dispersion of colloidal and non-colloidal particles in a liquid medium and, where the material includes $Al_2O_3$, the colloidal particles may, for example, be colloidal boehmite. This method has the advantage of producing particles of uniform composition.

The material for thermal spraying may be in particulate form having, for example a mean particle size in the range of 2 to 30 $\mu$m. The particles may be of regular or irregular shape. In practice, spherical particles may be relatively easier to handle when thermal spraying. Generally, it is found that the finest particles give rise to the smoothest coatings with the highest dielectric strength.

The chemical nature, quantitative and qualitative composition, physical form and size of the material for thermal spraying may be varied to optimise the properties of the coating in order to meet specific requirements. However, it is clearly essential that the coating is compatible with subsequently applied material constituting an electronic circuit.

The coating may be produced with a desired thickness by carrying out one or more successive thermal spraying operations. For example, where the coating is required to have high voltage breakdown characteristics, it may have a thickness in the range of 200 μm to 300 μm and, where lower voltage breakdown characteristics are required, it may be about 50 μm. The above figures are for guidance only and it is possible that, in some cases, the nature of the substrate may influence the voltage breakdown characteristics of the coating. The coating may, if desired, comprise a series of graded layers where individual layers may be provided with different properties and/or materials from other layers. Such individual layers may readily be provided in successive thermal spraying operations. It should also be noted that the coating may be provided to cover part of or all of the surface area of the substrate. For example, where the latter is a lamina, the coating may be provided on one side only either completely or partly or on both sides either completely or partly. Also, the coating produced may have a small degree of porosity, for example less than 10% porosity.

The coating produced by thermal spraying may be insufficiently smooth for it to be compatible with a material (e.g.) an ink used to provide an electronic circuit thereon. Thus, its smoothness may need to be enhanced and this could be done, for example, by contacting the coated substrate with a dispersion of particulate material, compatible with the coating, in a liquid medium followed by drying and firing. The particulate material may, for example, be colloidal. In a particular example, a mixture of alumina and silica was applied to a substrate in order to enhance smoothness. However, an additional coating such as the above may be provided for reasons other than enhancing smoothness and may be of a material dissimilar to the material constituting the coating produced by thermal spraying.

The substrate is preferably metallic though it may be fabricated of a non-metallic material, for example a plastics material, or a ceramic material or a combination of a metallic and a non-metallic material. Examples of metallic substrates are Cu, Al, Ti, Mo, low C steels, stainless steels, and aluminium bearing ferritic steels, for example having the following composition by weight: 10 to 30% Cr, 1 to 10% Al, 0 to 0.5% C and the balance Fe. Examples of such steels may be available in the UK under the UK Registered Trade Mark "FECRALLOY", where the steel composition includes a small proportion of Y. Preferred aluminium bearing ferritic steels have the composition by weight of up to 20% Cr, 1 to 10% Al, 0.1 to 3.0% Y and the balance Fe, and particularly preferred steels have the composition by weight of 15.5 to 16.5% Cr, 4.6 to 5.6% Al, 0.3 to 1.0% Y and the balance Fe. In practice, the selection of a suitable substrate material will be determined by consideration and assessment of a number of factors. Also, it may be necessary in some cases to subject the substrate to a pretreatment, which may be chemical or mechanical or both, before providing the coating.

The dielectric strength of the coating may be measured by methods known in the art; coatings produced according to the invention have been found capable of withstanding DC voltages of more than 4 Kv without breaking down.

The coated substrate of the invention may be fabricated into an electronic device by methods known in art. For example, electronic circuitry may be provided thereon by screen printing or vacuum evaporation together with appropriate electrical connections. Thus, conductors and/or resistors may be provided and any components connected to the conductor(s) as desired. The circuitry may, for example, be in the form of a hybrid circuit. Several ways of carrying out the invention will now be described in detail by way of example only as follows. All proportions given below are by weight.

### Example 1

An alumina sol was prepared by dispersing 1 kg of a flame hydrolysed alumina powder in 4.5 l of 0.02 M nitric acid. The sol contained 219 g $l^{-1}$ of $Al_2O_3$ equivalent and had a density of 1.14 g/cc. To 0.326 l of the sol was added 0.89 l of an $\alpha$-alumina powder in slurry form (0.720 kg $Al_2O_3$) followed by 0.290 kg of magnesium oxide with a fine particle size. No adverse effects such as coagulation or significant viscosity changes occurred during the mixing operations and the sol-slurry mixture was diluted to 6.2 l with demineralised water. The feed solution with a $MgO/Al_2O_3$ mole ratio = 1.0 had a pH of 11.3, density 1.12 g/cc and contained 146 g $l^{-1}$ of total oxide.

The stirred slurry was fed to a NIRO Mobile Minor spray dryer at 2.8 l $hr^{-1}$ and yielded 0.937 kg of a free-flowing spherical gel powder containing 96 % oxide and with a tap density of 0.7 g/cc. Examination by microscopy showed the powder was comprised of spherical particles in the size range 5 to 30 $\mu$m with a mean size of 11.2 $\mu$m. When calcined at 900°C for 1 hour the spherical particles retained their shape to give an oxide product (0.86 kg) with a tap density of 0.71 g/cc and a composition of 72% $Al_2O_3$ : 28% MgO.

The powder was then plasma sprayed onto a FECRALLOY steel substrate using plasma spraying equipment known in the art. The dielectric strength of the coating formed, which had a thickness of 240 $\mu$m, was measured by applying a steadily increasing DC potential difference between a first contact pad on the exposed surface of the coating and a second contact pad on the side of the lamina remote from the coating. It was found that the coating was capable of withstanding a DC voltage of 4600 V without breaking down. The surface roughness (Ra) of the coating was found, in standard tests, to be 4.5 $\mu$m.

An electronic circuit was applied to the coated substrate as follows. An interdigitated pattern of a commercially available Ag/Pd conductor composition (ex ESL) comprising a dispersion of Ag particles as the major component and Pd particles as the minor component is an organic vehicle was applied to the coated substrate by screen printing using standard screen printing equipment (ex DEK). The organic vehicle was removed by air drying at 110°C for 15 minutes, and the Ag and Pd particles caused to sinter together and to the coating material by firing in air at a peak temperature of 850°C in a moving belt furnace.

### Example 2

An alumina sol was prepared by dispersing a commercially available alumina monohydrate (boehmite) powder in dilute nitric acid. The sol containing 244 g $1^{-1}$ alumina equivalent was diluted with 3.9 l of demineralised water and then mixed with 0.22 l of a magnesium nitrate solution containing 113 g $1^{-1}$ magnesium oxide equivalent to give a mixture (4.1 l) containing 121 g $1^{-1}$ total oxide nominally 5% MgO - 95% $Al_2O_3$.

The dispersion was spray dried at 2.9 l hr$^{-1}$ at a inlet temperature of 220°C and outlet temperature of 100°C to give a spherical gel powder with particles in the size range 5 - 30 $\mu$m and with a tap density of 1.15 g/cc. After calcining at 900°C the powder had a tap density of 1.10 g/cc and a composition of 95% $Al_2O_3$ : 5% MgO.

The powder was plasma sprayed onto a variety of substrates and the resulting coating tested as described in Example 1. Similar results to those of Example 1 were obtained. Also, an electronic circuit was applied to the coated substrate as described in Example 1.

Example 3

An alumina sol (0.975 l) containing 231 g l$^{-1}$ alumina equivalent was mixed with a silica sol (0.025 l) containing 366 g l$^{-1}$ silica equivalent to give a mixture nominally 5% $SiO_2$ - 95% $Al_2O_3$. The mixed sol (pH 3.8) was stable to coagulation and precipitation and had a viscosity of 25 cp at 23°C. The sol was spray dried (inlet 225°C, outlet 100°C) to give a spherical gel powder product with particles in the size range 5 - 30 $\mu$m and with a tap density of 1.09 g/cc. After calcination the powder had a tap density of 0.8 g/cc and a composition of 95% $Al_2O_3$ : 5% $SiO_2$.

The powder was plasma sprayed onto a variety of substrates and the resulting coating tested as described in Example 1. Similar results to those of Example 1 were obtained. Also, an electronic circuit was applied to the coated substrate as described in Example 1.

### Example 4

A spherical gel powder product containing 4% $SiO_2$ - 96% $Al_2O_3$ with particles in the size range 5 - 15 $\mu$m was prepared in a similar way to that described in Examples 1 to 3. The powder was plasma sprayed, as described in Examples 1 to 3, onto a FECRALLOY steel substrate. The properties of the resulting coating were found to be as follows: thickness 280 $\mu$m, surface roughness 2.4 $\mu$m, and voltage breakdown 6000 V. Also, an electronic circuit was applied to the coated substrate as described in Example 1.

### Example 5

Flame hydrolysed alumina powder (96 g) was added to 1 l of a silica sol containing 4 g of $SiO_2$ equivalent to give a stable mixed sol containing 100 g l- total oxide and with the nominal composition, 96% $Al_2O_3$ - 4% $SiO_2$. This sol was carefully applied onto a plasma sprayed lamina prepared as described in Example 3 to impregnate the coating and then heat-treated in air at 500°C. The texture and smoothness of the resulting coating were better than those of the original plasma-sprayed coating; in this way, surface roughness could be reduced from typically 4 $\mu$m to 1 $\mu$m or less. Also, an electronic circuit was applied to the coated substrate as described in Example 1.

Example 6

Aluminium sec-butoxide (88 g) was diluted with 15 ml of xylene and then mixed with 6 g of silicon-aluminium ester to give a nominal composition of 5% $SiO_2$ - 95% $Al_2O_3$; the solution contained the equivalent of 200 g $l^{-1}$ of total oxide. The fluid mixture was used to impregnate a plasma-sprayed coatings on a lamina as described in Example 4 above and after heat-treating at 500°C. The resulting coating was significantly smoother than that of the original plasma-sprayed coating and had similar properties to the final coating produced in Example 5. Also, an electronic circuit was applied to the coated substrate as described in Example 1.

Example 7

A mixture of a boehmite sol and a silicone glycol copolymer of composition such that on firing it would give 96% $Al_2O_3$ and 4% $SiO_2$ was prepared and applied to a plasma-sprayed coating prepared as described in Example 3, followed by drying and firing at 850°C. The final coating was found to be of a smoothness similar to that of the final coatings produced in Examples 5 and 6. Also, an electronic circuit was applied to the coated substrate as described in Example 1.

Claims

1. A method of making a coated substrate for use in the manufacture of an electronic device by providing an adherent coating on a substrate, characterised in that the coating is produced by thermally spraying a material onto the substrate, the material and conditions of spraying being such that the coating has controlled properties for electronic purposes.

2. A method as claimed in claim 1 wherein the coating is a dielectric coating.

3. A method as claimed in claim 1 or claim 2 wherein the material comprises one or more refractory oxides.

4. A method as claimed in claim 2 wherein the material comprises a mixture of alumina and silica.

5. A method as claimed in any of the preceding claims wherein the substrate is metallic.

6. A method as claimed in any of the preceeding claims wherein the material, before thermal spraying, has a mean particle size in the range of 2 to 30 μm.

7. A method as claimed in any of the preceding claims wherein the coated substrate is contacted with a dispersion·of particulate material in a liquid medium followed by drying and firing.

8. A method as claimed in any of the preceding claims wherein the coated substrate is fabricated into an electronic device.

0115412

9.  A method as claimed in claim 8 wherein electronic circuitry is provided on the coated substrate.

13338 MlH (EPO)